# DEMANDE DE BREVET EUROPEEN

(11) **EP 1 482 558 A2**
(43) Date de publication de la demande: **01.12.2004**
(21) Numéro de dépôt: 04300303.7
(22) Date de dépôt: 25.05.2004
(51) Int. Cl.: H01L 27/146

(54) **Matrice de photodétecteurs**

(30) Priorité: 26.05.2003 FR 0306343
(71) Demandeur: STMicroelectronics S.A., 92120 Montrouge (FR)
(72) Inventeur: Roy, François, 38180 Seyssins (FR)
(74) Mandataire: de Beaumont, Michel

(57) **Abrégé**

L'invention concerne une matrice de photodétecteurs réalisée sous forme monolithique, dans laquelle des transistors sont formés dans un substrat semiconducteur revêtu de plusieurs niveaux de métallisations et des photodiodes sont formées au-dessus d'un dernier niveau de métallisation, chaque photodiode comportant une région supérieure d'un premier type de conductivité commune à toutes les photodiodes et une région inférieure individuelle formant une jonction avec la région supérieure en contact avec une métallisation du dernier niveau, caractérisée en ce que chaque région inférieure est séparée des régions inférieures voisines par un matériau isolant et est reliée à la métallisation par l'intermédiaire d'un via formé dans au moins une couche isolante.

## Description

La présente invention concerne des matrices de photodétecteurs destinées à être utilisées comme capteurs d'image dans des dispositifs de prises de vue tels que, par exemple, des caméras, des caméscopes, des microscopes numériques ou encore des appareils photographiques numériques. Plus particulièrement, la présente invention concerne de telles matrices réalisées sous forme monolithique.

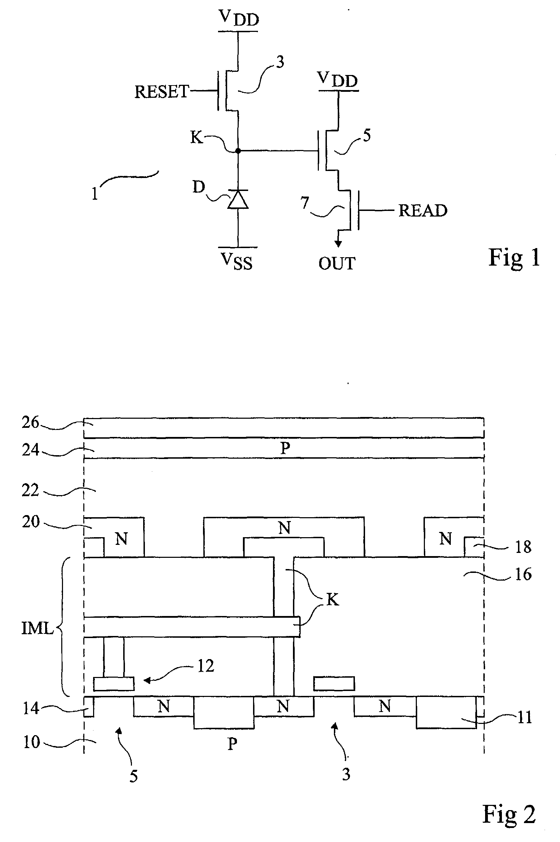

La figure 1 illustre un schéma de principe d'une partie d'une cellule élémentaire 1 d'une matrice de photodétecteurs. La cellule 1 comporte une photodiode D dont l'anode est reliée à une ligne d'alimentation basse de référence VSS. La cathode de la diode D est reliée à une borne K de précharge et de détection. La borne K est reliée à une ligne d'alimentation haute VDD par l'intermédiaire d'un transistor MOS de précharge 3 dont la grille reçoit un signal de commande de précharge RESET. La borne K est également connectée à la grille d'un transistor MOS de transfert 5 interposé entre l'alimentation haute VDD et le drain d'un transistor de commande de lecture 7. La source du transistor 7 constitue la borne de sortie OUT de la cellule 1 et sa grille reçoit un signal de commande de lecture READ.

On considère dans la présente description une filière technologique dans laquelle au moins les transistors 3, 5 et 7 de la cellule 1 sont réalisés dans un circuit intégré revêtu de niveaux de métallisation, la photodiode D étant formée au-dessus du dernier niveau de métallisation.

La figure 2 illustre, schématiquement et partiellement, un mode d'intégration connu de certains des éléments de la figure 1.

Les transistors 3 et 5 sont formés dans un substrat semiconducteur 10, typiquement de silicium monocristallin, généralement de type P. Plus particulièrement, chaque transistor 3, 5 est formé dans une zone active du substrat 10 définie, par exemple, par des tranchées isolantes 11. Pour chaque transistor 3, 5, une région de canal, définie par une grille isolée respective 12 posée sur le substrat 10, sépare des régions de source/drain 14 de type N formées dans le substrat 10. Au-dessus du substrat 10 sont superposés des niveaux de métallisation intermédiaires désignés de façon globale par la référence IML. Les niveaux IML comportent des métallisations noyées dans au moins un matériau isolant et destinées, notamment, à former la borne K et à ramener un contact sous la forme d'un plateau métallique 18 d'un dernier niveau de métallisation au-dessus d'une couche d'isolement supérieure 16.

Une cathode 20 d'une photodiode D encapsule le plateau 18. La cathode 20 résulte d'un dépôt à basse température, de l'ordre de 200°C. La cathode 20 est, par exemple, en silicium amorphe dopé de type N. La cathode 20 de chaque photodiode D est individualisée et distincte des cathodes des photodiodes des cellules voisines. L'anode de la diode D est commune à plusieurs photodiodes, généralement au moins à toutes les photodiodes d'une rangée ou colonne de la matrice. L'anode commune est constituée d'un empilement d'une couche 22 de silicium amorphe non dopée et d'une couche supérieure 24 dopée de type P. La couche 24 est recouverte d'une couche métallique transparente 26 de type ITO, destinée par exemple à être reliée à l'alimentation basse VSS.

Un inconvénient de la structure précédente réside dans le fait que l'image restituée présente des points blancs ou des défauts d'obscurité. Un tel dysfonctionnement est lié à l'apparition de courants de fuite entre les régions 20 et 22, notamment lorsque la distance entre cathodes est réduite et que les cathodes sont à leur niveau de polarisation maximale, généralement compris entre 1,5 et 2 V.

Pour pallier ces dysfonctionnements, et donc supprimer les courts-circuits, on a proposé d'accroître les dimensions de l'intervalle séparant deux cathodes par rapport à leurs valeurs minimales déterminées par les caractéristiques électriques et géométriques (dopages et épaisseurs) des électrodes. Cette solution va à l'encontre de la volonté d'optimisation du nombre de cellules formées dans une surface d'intégration donnée.

Un objet de la présente invention est de proposer une structure qui présente une densité accrue.

Un objet de la présente invention est de proposer une telle structure qui ne présente pas les dysfonctionnements des structures existantes.

Un autre objet de la présente invention est de proposer un procédé de fabrication d'une telle structure.

Pour atteindre ces objets, la présente invention prévoit une matrice de photodétecteurs réalisée sous forme monolithique, dans laquelle des transistors sont formés dans un substrat semiconducteur revêtu de plusieurs niveaux de métallisations et des photodiodes sont formées au-dessus d'un dernier niveau de métallisation, chaque photodiode comportant une région supérieure d'un premier type de conductivité commune à toutes les photodiodes et une région inférieure individuelle formant une jonction avec la région supérieure en contact avec une métallisation du dernier niveau, chaque région inférieure étant séparée des régions inférieures voisines par un matériau isolant et étant reliée à la métallisation par l'intermédiaire d'un via formé dans au moins une couche isolante.

Selon un mode de réalisation de la présente invention, la région inférieure est en silicium amorphe dopé de type N.

Selon un mode de réalisation de la présente invention, la région inférieure est en un matériau métallique propre à former une jonction Schottky avec la région supérieure.

Selon un mode de réalisation de la présente invention, la région inférieure est en chrome.

Selon un mode de réalisation de la présente invention, l'au moins une couche isolante comprend une couche d'oxyde de silicium et une couche de nitrure de silicium.

Selon un mode de réalisation de la présente invention, la région supérieure est une couche de silicium amorphe non dopée.

Selon un mode de réalisation de la présente invention, la région supérieure est recouverte d'une couche de silicium amorphe dopée de type P.

Selon un mode de réalisation de la présente invention, la région supérieure est recouverte d'une couche métallique transparente.

Selon un mode de réalisation de la présente invention, le matériau isolant séparant deux régions inférieures voisines est de l'oxyde de silicium.

La présente invention prévoit également un procédé de formation d'une photodiode d'une matrice de photodétecteurs au-dessus d'un dernier niveau de métallisation d'un circuit intégré, des transistors de la matrice étant formés dans un substrat semiconducteur et des niveaux de métallisation intermédiaires superposés au substrat, comportant les étapes suivantes :
former sur le dernier niveau de métallisation un plateau métallique noyé dans un matériau isolant et contactant des bornes de certains des transistors ;
déposer au moins une couche isolante de façon que sa surface supérieure est sensiblement plane ;
déposer et graver un matériau isolant de façon à découvrir la couche isolante supérieure selon le contour d'une région inférieure de la photodiode ;
ouvrir les portions découvertes de la couche isolante supérieure puis ouvrir la couche isolante inférieure de façon à découvrir partiellement le plateau ;
déposer entre et sur les portions maintenues en place du matériau isolant un matériau propre à constituer la première région ;
procéder à un polissage mécano-chimique de façon à découvrir la surface supérieure des portions ; et
déposer un matériau semiconducteur propre à former une région supérieure de la photodiode.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, qui a été décrite précédemment, illustre le schéma de principe d'une partie d'une cellule élémentaire d'une matrice de photodétecteurs ;
la figure 2, qui a été décrite précédemment, illustre, en vue en coupe partielle et schématique, un mode d'intégration connu d'une matrice de photodétecteurs ; et
la figure 3 illustre, en vue en coupe partielle et schématique, une matrice de photodétecteurs intégrée selon un mode de réalisation de la présente invention.

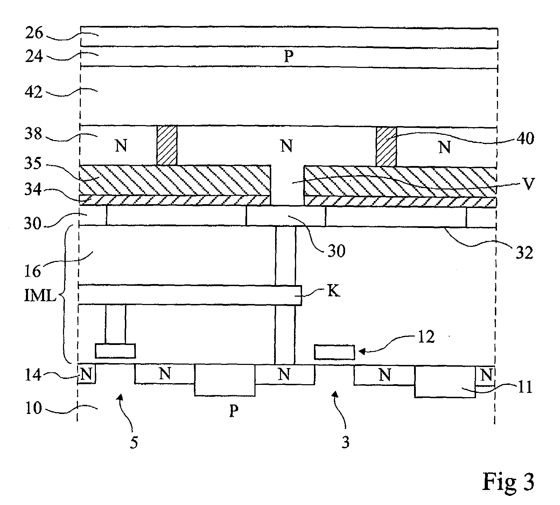

Par souci de clarté, les mêmes éléments ont été désignés par les mêmes références aux différentes figures et, de plus, comme cela est habituel dans la représentation des circuits intégrés, les vues en coupe des figures 2 et 3 ne sont pas tracées à l'échelle. Par souci de simplification, seuls les éléments nécessaires à la compréhension de la présente invention ont été représentés ou décrits. En particulier, les structures des transistors 3, 5 et 7 de la figure 1 et des niveaux de métallisations intermédiaires ne sont ni décrites, ni représentées en détail aux figures 2 et 3.

La figure 3 est une vue en coupe partielle et schématique d'un mode d'intégration selon la présente invention d'une matrice de photodétecteurs. La vue en coupe de la figure 3 est centrée autour d'une cellule élémentaire similaire à la cellule 1 de la figure 1. Par souci de simplification, seules les différences entre les figures 2 et 3, c'est-à-dire la partie de la structure formée au-dessus de la couche isolante 16, sont décrites par la suite.

Le dernier niveau de métallisation comporte des plateaux métalliques distincts 30 séparés par des portions d'une couche isolante 32. Chaque plateau 30 correspond à une borne K d'une cellule élémentaire respective. La surface supérieure des plateaux 30 et de la couche 32 est sensiblement plane et est recouverte d'au moins une couche isolante, par exemple deux couches isolantes successives 34 et 35. La couche isolante inférieure 34 est, de préférence, de même nature que la couche isolante 32. La couche supérieure 35 est, de préférence, gravable sélectivement par rapport à la couche inférieure 34. Par exemple, la couche 34 est une couche d'oxyde de silicium (SiO₂), alors que la couche supérieure 35 est une couche de nitrure de silicium (Si₃N₄). La surface supérieure de la couche supérieure 35 est sensiblement plane. La couche 35 porte des cathodes individuelles 38 des photodiodes D de la matrice. Les cathodes 38 sont constituées, par exemple, de silicium amorphe déposé à basse température (de l'ordre de 200°C) dopé de type N. Chaque cathode 38 est en contact avec un plateau 30 respectif, au moyen d'un via conducteur V formé dans les couches isolantes 35 et 34.

L'intervalle entre deux cathodes 38 est rempli d'un matériau isolant 40. La surface supérieure des cathodes 38 et de la couche de remplissage intermédiaire 40 est sensiblement plane. Une couche d'anode 42 recouvre l'ensemble des cathodes 38 et de leur séparation isolante 40. La couche 42, destinée à constituer l'anode commune de photodiodes, est recouverte d'une couche semiconductrice 24 revêtue d'une couche métallique transparente 26. La couche d'anode 42 est par exemple en silicium amorphe non dopé alors que la couche semiconductrice 24 est en silicium amorphe dopé de type P.

L'écart entre deux cathodes 38, c'est-à-dire l'intervalle rempli du matériau isolant 40, peut avantageusement être réduit au minimum théoriquement suffisant pour permettre un isolement stable de cathodes 38 voisines. Ce minimum est déterminé par le niveau de polarisation maximal des cathodes, leur conductivité (dopage) et la valeur de la constante diélectrique de l'isolant 40.

La matrice résultante présente des taux de dysfonctionnements réduits par rapport aux structures connues. En effet, la suppression des portions de la couche d'anode non dopée séparant deux cathodes permet de supprimer une source importante de dysfonctionnements.

En outre, cela permet d'augmenter la densité des cellules d'une matrice, car l'écart entre deux photocathodes 38 de la structure de la figure 3 est réduit par rapport à l'écart homologue entre deux photocathodes 20 de la figure 2.

Un autre avantage de la présente invention réside en ce qu'une ou plusieurs couches de passivation peuvent recouvrir le dernier niveau de métallisation 30-32. Ces couches peuvent être maintenues en place et les vias V les traversent également. Au contraire, dans les matrices classiques, ces couches sont non formées. La présente invention permet alors d'éliminer des dysfonctionnements liés à une manipulation des circuits alors que les métallisations supérieures sont apparentes.

La structure de la figure 3 peut être obtenue, par exemple, par le procédé suivant. Après définition des plateaux métalliques 30, une couche isolante 32 est déposée et aplanie, par exemple par un polissage mécano-chimique (CMP), de façon à découvrir la surface supérieure des plateaux 30. On dépose ensuite la couche isolante inférieure 34.

Selon une variante, les couches 32 et 34 étant de même nature, on dépose après définition des plateaux 30 une seule couche isolante destinée à noyer les plateaux métalliques 30.

Selon une autre variante, les plateaux 30 sont formés selon un procédé de type damascène, la couche isolante 32 étant déposée puis ouverte selon le motif des plateaux 30 avant de déposer un matériau métallique puis de procéder à un polissage CMP de façon à découvrir les portions de la couche 32 maintenues en place.

Le procédé se poursuit par le dépôt de la couche isolante 35. Ensuite, une couche isolante 40 peut être déposée, puis ouverte selon le motif que l'on souhaite conférer aux cathodes 38. Ensuite, l'empilement des couches isolantes 35 et 34 (ou 35 et 32) est ouvert de façon à découvrir les plateaux 30. On dépose alors une couche propre à former les vias V et les cathodes 38, telle que, par exemple, du silicium amorphe. Enfin, on aplanit la structure par exemple au moyen d'un polissage CMP. La structure est ensuite complétée par des dépôts successifs des régions 42, 24 et 26.

Un avantage d'un tel procédé réside dans le polissage CMP effectué avant la formation de l'anode 42. Outre les avantages décrits précédemment, cela permet d'obtenir une interface régulière entre les cathodes et l'anode. Cela réduit encore les dysfonctionnements de la matrice.

Bien entendu, la présente invention est susceptible de diverses variantes et modifications qui apparaîtront à l'homme de l'art. En particulier, l'homme de l'art saura adapter les matériaux utilisés à une filière technologique donnée. Ainsi, la présente invention a été décrite dans le cas de cathodes constituées de silicium amorphe dopé de type N. Toutefois, les cathodes peuvent être en un métal propre à constituer une jonction de type Schottky avec l'anode, tel que, par exemple, du chrome.

De façon similaire, on a considéré que les vias V sont constitués du matériau constituant les cathodes 38. Toutefois, ils peuvent être constitués d'un matériau différent, déposé puis gravé avant la formation des cathodes 38.

De plus, on a indiqué précédemment que la valeur de l'écart entre deux cathodes 38 dépend des caractéristiques géométriques et électriques des cathodes et du matériau isolant 40. Toutefois, l'homme de l'art comprendra qu'il dépend également des possibilités de gravure du matériau 40, lorsque celui-ci est déposé avant formation des cathodes 38. Réciproquement, si les cathodes 38 sont formées (individualisées) puis le matériau 40 déposé, l'écart dépend alors des possibilités de gravure du matériau constituant les cathodes 38 et de dépôt du matériau 40.

Par ailleurs, on notera que par substrat on a désigné autant des tranches semiconductrices uniformément dopées que des zones épitaxiées et/ou spécifiquement dopées par diffusion/implantation formées sur ou dans un substrat massif. En outre, l'homme de l'art saura compléter la structure décrite précédemment par tout élément nécessaire au fonctionnement du dispositif global. En particulier, l'homme de l'art saura réaliser le transistor 7 de la figure 1 et diverses sources propres à fournir les signaux d'alimentation VDD, VSS ou de commande RESET, READ. De façon similaire, la structure réelle des niveaux de métallisation intermédiaires IML n'a pas été détaillée. L'homme de l'art saura réaliser dans ces niveaux toute connexion nécessaire entre différents éléments formés dans le substrat.

L'homme de l'art saura adapter la présente invention à l'application recherchée. Ainsi, la présente invention n'est pas limitée à des matrices comportant la structure de base de la figure 1 mais s'applique à toute matrice de photocapteurs utilisant des photodiodes formées au-dessus d'un dernier niveau de métallisation d'un circuit intégré. En particulier, le nombre d'éléments autres que la photodiode tels que les transistors 3, 5 et 7 constituant une cellule élémentaire ou pixel peut être plus élevé ou plus réduit.

L'homme de l'art saura également adapter les matériaux des diverses couches conductrices et/ou isolantes en fonction d'une filière de fabrication utilisée.

## Revendications

1. Matrice de photodétecteurs réalisée sous forme monolithique, dans laquelle des transistors (3, 5, 7) sont formés dans un substrat semiconducteur (10) revêtu de plusieurs niveaux de métallisations (IML) et des photodiodes (D) sont formées au-dessus d'un dernier niveau de métallisation, chaque photodiode comportant une région supérieure d'un premier type de conductivité (42, 24, 26) commune à toutes les photodiodes et une région inférieure individuelle (38) formant une jonction avec la région supérieure, ladite région individuelle étant en contact avec une métallisation (30) dudit dernier niveau, **caractérisée en ce que** chaque région inférieure est séparée des régions inférieures voisines par un matériau isolant (40) et est reliée à ladite métallisation par l'intermédiaire d'un via (V) formé dans au moins une couche isolante (34, 35).

2. Matrice de photodétecteurs selon la revendication 1, **caractérisée en ce que** la région inférieure (38) est en silicium amorphe dopé de type N.

3. Matrice de photodétecteurs selon la revendication 1, **caractérisée en ce que** la région inférieure (38) est en un matériau métallique propre à former une jonction Schottky avec la région supérieure (42).

4. Matrice de photodétecteurs selon la revendication 3, **caractérisée en ce que** la région inférieure (38) est en chrome.

5. Matrice de photodétecteurs selon la revendication 1, **caractérisée en ce que** ladite au moins une couche isolante comprend une couche (34) d'oxyde de silicium et une couche (35) de nitrure de silicium.

6. Matrice de photodétecteurs selon la revendication 1, **caractérisée en ce que** la région supérieure (42) est une couche de silicium amorphe non dopée.

7. Matrice de photodétecteurs selon la revendication 1, **caractérisée en ce que** la région supérieure (42, 24) est recouverte d'une couche de silicium amorphe dopée de type P.

8. Matrice de photodétecteurs selon la revendication 1, **caractérisée en ce que** la région supérieure (42, 24) est recouverte d'une couche métallique transparente (26).

9. Matrice de photodétecteurs selon la revendication 1, **caractérisée en ce que** le matériau isolant (40) séparant deux régions inférieures voisines (38) est de l'oxyde de silicium.

10. Procédé de formation d'une photodiode (D) d'une matrice de photodétecteurs au-dessus d'un dernier niveau de métallisation d'un circuit intégré, des transistors (3, 5, 7) de la matrice étant formés dans un substrat semiconducteur (10) et des niveaux de métallisation intermédiaires (IML) superposés audit substrat, **caractérisé en ce qu'**il comporte les étapes suivantes :
former sur le dernier niveau de métallisation un plateau métallique (30) noyé dans un matériau isolant (32) et contactant des bornes (K) de certains desdits transistors (3, 5) ;
déposer au moins une couche isolante (34, 35) de façon que sa surface supérieure est sensiblement plane ;
déposer et graver un matériau isolant de façon à découvrir la couche isolante supérieure selon le contour d'une région inférieure de la photodiode ;
ouvrir les portions découvertes de la couche isolante supérieure puis ouvrir la couche isolante inférieure de façon à découvrir partiellement ledit plateau ;
déposer entre et sur les portions (40) maintenues en place dudit matériau isolant un matériau propre à constituer la première région ;
procéder à un polissage mécano-chimique de façon à découvrir la surface supérieure desdites portions ; et
déposer un matériau semiconducteur propre à former une région supérieure (42) de ladite photodiode.
